# EUROPEAN PATENT SPECIFICATION

(11) **EP 2 390 577 B1**
(45) Date of publication and mention of the grant of the patent: **10.07.2013**
(21) Application number: 10005608.4
(22) Date of filing: 28.05.2010
(51) Int. Cl.: F24C 7/08, H05K 5/00

(54) **Method of mounting a user interface for an appliance of household or industrial type**
Methode zur Montage einer Benutzerschnittstelle für ein Haushalts- oder ein Industriegerät
Procédé pour le montage d'une interface utilisateur pour un appareil électroménager ou un appareil industriel

(43) Date of publication of application: 30.11.2011
(73) Proprietor: Electrolux Home Products Corporation N.V., 1130 Brussel (BE)
(72) Inventor: Winkelmann, Klaus, 63688 Gedern (DE); Taubner, Franz, 90763 Fürth (DE); Feser, Jürgen, 90765 Fürth (DE); Bunzel, Volkmar, 73432 Aalen (DE)
(74) Representative: Meissner, Bolte & Partner

(56) References cited:
- EP-A2- 2 063 533
- DE-A1- 19 651 821
- DE-A1-102008 041 516
- GB-A- 2 064 879

## Description

The present application is related to user interfaces, in particular to a method of mounting a user interface for an appliance of household or industrial type.

A user interface for a cooking hob is known from DE 100 15 973 A1, for example. The user interface comprises an electronic board that is snap-connected to a mounting frame which is glued to a lower side of the cooking hob. The electronic board is mounted to the mounting frame via a push-and-rotate movement in that it is first inserted into an anchor section engaging an outer rim section thereof, and then it is rotated such that snap hooks engage an opposite rim section.

DE 199 50 829 A1 discloses a user interface for a baking oven. The user interface comprises a fixture to which an electronic interface unit is secured by means of a clamping frame which frame is snap-connected to the fixture.

Further user interfaces and related mounting methods are known from DE 196 51 821 A1, DE 10 2008 041 516 A1, EP 2 063 533 A1 and GB 2 064 879 A.

It is an object of the invention to provide a method of mounting a user interface for an appliance of household or industrial type, with which the user interface can be easily assembled and disassembled and which allows to reliably and precisely position and fix components of the user interface.

This object is achieved by independent claim 1. Embodiments in particular result from the dependent claim.

The present application in general is related to user interfaces for appliances of household or industrial type, especially for domestic appliances. The user interface comprises at least one control unit, i.e. a touch-field unit. The touch-field unit may be of infrared or capacitive type and adapted to allow a user to select or adjust certain parameters for operating the appliance in touching a respective touch panel presented to the user. The touch-field unit comprises one or more individual touch-field elements or sensors. The control unit may comprise further active and passive actuators or control elements such as push and/or rotating type buttons, sliders and the like. A control unit in the sense of the present invention in particular shall allow a user to at least partially control the operation of a respective appliance, i. e. it shall allow active user intervention.

The user interface further comprises at least one electronic board. The electronic board may comprise electronic components for operating and controlling the control unit, i.e. touch-field unit, and, if adequate, the appliance or at least some functions thereof.

The at least one control unit, i.e. touch-field unit, and electronic board, - at least a respective pair of such elements - are detachably mounted with at least partial overlap in successive planes via snap connectors to a common mounting frame of the user interface. Further they are arranged and designed such that electronic contact between mutual contact elements, i.e. connector strips thereof is automatically established upon mounting the respective control unit, i.e. touch-field unit, and electronic board to the mounting frame. Electric contact elements of a respective connector strip project from the back side of the touch-field unit. Further, the connector strips are arranged in a region of overlap on respective sides of the touch-field unit and electronic board facing each other.

The user interface is assembled according to the method as set out in claim 1.

Obviously, automatically establishing electrical contact greatly simplifies the mounting process. In addition, faulty electric contacting can largely be prevented.

The user interface may comprise a fixture, which may be a front fixture to be positioned at or attached to a front panel of the appliance. A transparent cover, preferably made of glass, a glass analogue material or plastic, is positioned on the fixture and fixed, if required. Further, the mounting frame may attached to the fixture, in particular to the transparent cover. The transparent cover may be part of a front or top face or cover plate presented and accessible to the user of the appliance. Transparency of the transparent cover in particular shall include all kinds of transparency and translucence.

The mounting frame is favourably attached to the fixture or transparent cover via glue or other suitable attachment means allowing safe and tight attachment. Here again, the mounting process is comparatively simple, straight forward and time saving.

As already stated, at least one pair of control unit and electronic board is arranged with at least partial overlap in successive planes, and the contact elements are arranged in a region of overlap on respective sides of the control unit and electronic board facing each other. This configuration allows the respective control unit and electronic board to be successively attached to the mounting frame whilst guaranteeing automatic electric contacting.

Attachment of the control unit and electronic board to the mounting frame and electric contacting can be achieved with respective single attachment movements or steps, not requiring separate and additional steps for establishing electrical contacts. Note that the term in successive planes shall in particular mean that the respective planes are parallel and arranged one behind the other relative to the fixture or transparent cover.

The electronic board may be detachably mounted to a positioning frame. The positioning frame in turn may be detachably mounted to the mounting frame or fixture. Guiding elements or rails and respective engagement elements can be provided, specially adapted to secure safe, easy and proper alignment of the positioning frame relative to the control unit, mounting frame and fixture, respectively. Note that guiding elements or rails and respective engagement elements also can be provided in connection with the control unit or other components of the user interface in order to secure proper and easy alignment thereof.

As indicated beforehand, the user interface may comprise further components, in particular electronic components. Hence, the user interface may comprise at least one actuator detachably mounted to at least one of the mounting frame and positioning frame. The actuator may be a switch, control knob, in particular a rotary and/or push type knob or button. Preferably, at least one of an electric or mechanic contact to actuating elements, such as switches or push buttons and the like, is automatically established upon mounting the actuator to the mounting frame. Such a configuration simplifies attachment of additional actuators and the like and contributes to rapid and safe assembly of the user interface.

The user interface may comprise at least one reflector unit arranged downstream the control unit. Downstream in particular shall apply to a side of the control unit, in particular touch-field unit averted from the fixture or transparent cover. In the regular mounting position of the user interface the side averted from the fixture or transparent cover can be named rear or back side, whereas the side of the transparent cover can be named front side which generally is presented to and faces towards a user of the appliance.

The reflector unit is preferably designed and adapted such that it presses or urges the control unit, in particular touch-field unit, against or towards the fixture or transparent cover. Further, it is preferred that the positioning frame is adapted and designed such that it presses at least one of the control unit, in particular touch-field unit, against the fixture or transparent cover and the reflector unit against the control unit, in particular touch-field unit. Such a configuration expediently urges the control unit against rear sides of the fixture or transparent cover, and the reflector against the control unit, in particular touch-field unit. In this way, at least the control unit, in particular touch-field unit, and the reflector can be tightly and firmly attached and fixed in respective desired positions, leading to enhanced operability and functionality.

At least one of the mounting frame, positioning frame and fixture may comprise at least one of snap elements and guides, in particular guide rails, designed and adapted to engage the at least one control unit, in particular touch-field unit, at least one electronic board, at least one actuator, at least one reflector and positioning frame, respectively. Such snap elements and guides preferably are adapted and designed for generating a pressing force towards the fixture or transparent cover, i. e. the components mentioned beforehand are pressed against or in a direction towards the fixture or transparent cover. Snap elements and guides provide easy and time saving assembly of the user interface. Also, the user interface can easily be disassembled for maintenance purposes for example, in particular in the case that one of the components has to be replaced.

It is of further advantage that at least one of the mounting frame, positioning frame and fixture comprises at least one of lateral stops, transversal stops and height or depth stops, arranged and adapted for proper alignment of the at least one touch-field unit, electronic board, actuator, reflector, the positioning frame and mounting frame, in particular relative to each other.

Using such stop elements, respective components of the user interface can be exactly oriented and positioned in at least two dimensions at respective levels, or even in three dimensions, relative to each other. This is of particular advantage because with the proposed user interface an electric contact between contact elements of the control unit and electronic board can be automatically established generally requiring proper pre-alignment of respective components in order to avoid damages to contact elements such as contact pins and the like.

In this context it shall be noted that the contact elements, such as contact pins and mating receptacles, can be part of respective mating connectors.

At least one spring element may be provided which is designed for generating a pressing force directed towards the fixture or transparent section. Preferably the spring element acts upon at least one of the control unit, in particular touch-field unit, electronic board, actuator and reflector. Such additional spring elements can be provided if pressing forces of snap-elements and so on are likely to fail with fixing or attaching respective components reliably and sufficiently strong. In particular regions of high mass or weight load can be additionally secured and affixed by such spring elements.

In a special configuration of the user interface that uses snap elements, at least one snap element which is already exerting a pressing force to a control field unit, electronic board, actuator and reflector may be designed and configured such that upon deflection of the snap element in a direction opposite or transverse to the pressing force, away from the respective component for example, a slanted detent face thereof being raised thereby causing yet further overlap or further pitch with an engagement face of the respective component. Upon releasing the snap element a pressing force higher than the pressing force prevailing beforehand results. Such a snap element greatly simplifies assembly of the user interface.

Such a favourable snap element can comprise a resilient clip and detent element resiliently attached or resiliently moulded to the clip. Here, the detent element can in principle move swing independently from the clip. It is in particular possible that the clip itself can be deflected relatively to a first pivot axis, and that the detent element can be deflected relatively to a second pivot axis running parallel and spaced from the first pivot axis.

The user interface can be used with a great variety of appliances, such as ovens, in particular baking ovens, cooking ovens and microwave ovens, cooking hobs, refrigerators, freezers, washing machines and dishwashers, for example.

Embodiments of the invention, in particular a method of mounting the user interface, will now be described in connection with the annexed figures, in which
- Fig. 1: shows a perspective back view of a user interface of a first embodiment;
- Fig. 2: shows a mounting frame of the user interface of Fig. 1;
- Fig. 3: shows a back view of the mounting frame with a touch-field unit being mounted thereto;
- Fig. 4: shows the touch-field unit of Fig. 3;
- Fig. 5: shows an electronic board to be mounted to the mounting frame;
- Fig. 6: shows a cross sectional partial view of the user interface;
- Fig. 7: shows a reflector;
- Fig. 8: shows a cross sectional view of the user interface with the reflector being mounted to thereto;
- Fig. 9: shows a back view of a user interface of a second embodiment;
- Fig. 10: shows a touch-field unit of the user interface of Fig.9;
- Fig. 11: shows a back view of a mounting frame of the user interface of Fig. 9;
- Fig. 12: shows a front view of a positioning frame;
- Fig. 13: shows a cross sectional view a user interface in an actuator region;
- Fig. 14: shows a detail of a snap connection;
- Fig. 15: shows an enlarged view of a snap connector.

The invention will now be described in connection with a user interface of a household cooking oven. However, this shall not be construed as limiting the scope of the invention. Rather, the invention can be applied and used in connection with any other type of household appliance, for example washing machines, dishwashers, microwave ovens, refrigerators, freezers and the like.

If not otherwise stated like elements are denoted by like reference signs throughout the figures. The figures may not be true to scale, and scales of different figures may be different.

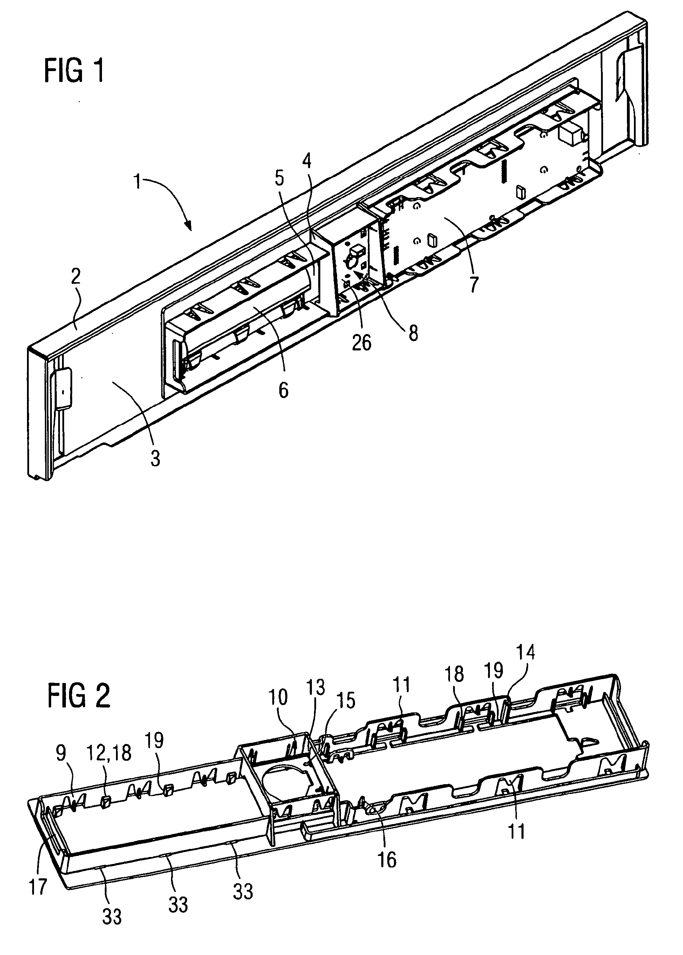

Fig. 1 shows in a perspective back view of a first embodiment of a user interface 1 of a cooking oven.

Note, that the term back view or back side shall mean that in the ordinary mounting position, the respective side is oriented towards the cooking oven or interior thereof and is therefore not visible from the outside. The term front view or front side shall mean that the respective side is oriented away from the appliance, if applicable visible from the outside.

The user interface 1 comprises a fixture 2 that can be attached to the cooking oven (not shown). A glass plate 3 is inlaid into the fixture 2, the front side of which constitutes a front face presented to a user of the cooking oven.

A mounting frame 4 of the user interface 1 is glued to the back side of the fixture 2, in more detail to the glass plate 3. A touch-field unit 5, a reflector 6 and an electronic board 7 are detachably mounted to the mounting frame 4. The mounting frame 4 further comprises a section to which an actuator 8, which may be a push and/or rotating type button, is detachably mounted to.

Fig. 2 shows the mounting frame 4 in more detail. The mounting frame 4 comprises first to third snap connectors 9, 10 and 11, which are designed and adapted for detachably mounting the touch-field unit 4, the electronic board 7 and actuator 8, at least a circuit board thereof.

Further, first to third guiding elements 12, 13, 14 are provided, which are designed and adapted to guide the touch-field unit 5, the electronic board 7 and actuator 8 during the process of mounting them to the mounting frame 4.

In addition, first and second positioning pins 15 and 16 are provided with the mounting frame 4. Furthermore, the mounting frame 4 comprises a lateral stop 17, several transversal stops 18 and several depth stops 19.

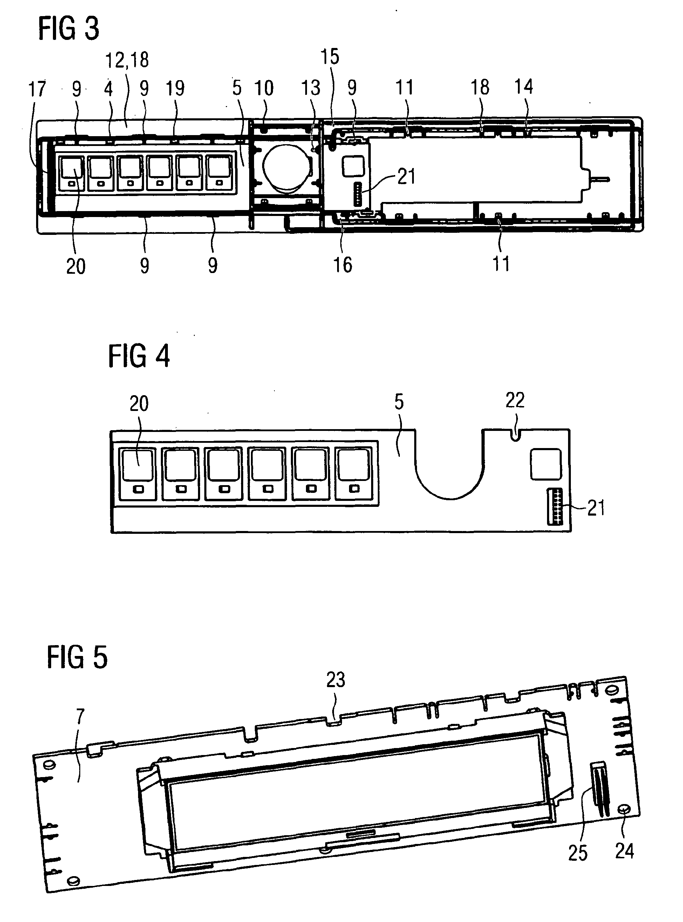

Fig. 3 shows a back view of the mounting frame 4 with the touch-field unit 5 being mounted thereto. As can be seen, the touch-field unit 5 comprises several touch sensors 20, and further a connector strip 21 with electric contact elements projecting from the back side of the touch-field unit 5.

The process of mounting the touch-field unit 5 to the mounting frame 4 is now described with particular reference to Fig. 3. Note that the terms right hand side and left hand side, upper and lower used insofar correspond to respective representation shown in the Figures.

The touch-field unit 5, which as such is shown in Fig. 4, is first pushed into the mounting frame 4 from the right hand side (Fig.3) towards the left hand side in a slightly tilted manner. The touch-field unit 5 is pushed into the mounting frame 4 underneath the section adapted to receive the actuator 8 whilst upper and lower edges of the touch-field unit 5 are guided by longitudinal guides respectively running from the right hand side to the left hand side. Here, guiding slots may be used. However, it is also possible that the first snap connectors 9, the first guiding elements and respective depth stops 19 additionally function as guiding elements.

The touch-field unit 5 is pushed towards the left hand side until its left face side abuts the lateral stop 17. At this stage, the touch-field unit 5, in particular its right hand side, is pressed downwards such that at least the first snap connectors 9 positioned right-hand the actuator mounting section engage the touch-field unit 5 in respective upper and lower edge sections. In doing so, a positioning notch 22 engages the first positioning pin 15.

After performing these steps, the touch-field unit 5 is detachably mounted to the mounting frame 4 with proper and fixed alignment in lateral, i. e. horizontal, and transverse, i. e. vertical, direction. Further, the level of the touch-field unit 5 is properly adjusted via the depth stops 19 or guiding elements, such as guide rails. In particular, horizontal and vertical movement as well as movement in depth direction can be prevented.

Fig. 5 shows in a front view the electronic board 7 to be mounted to the mounting frame 4. The electronic board 7 is mounted to the mounting frame 4 as follows: The electronic board is put onto the right hand side of the mounting frame 4 (Fig. 3), in more detail onto the third snap connectors 11. The electronic board 7 is positioned in such a way that the third guiding elements 14 engage respective guiding notches 23, and that the second positioning pin 16 engages a positioning hole 24 of the electronic board 7. Note that at least one guiding notch 23 and a respective third guiding element 14 may be adapted to properly center the electronic board 7 in horizontal direction. Further, some of the third guiding elements 14 may be adapted to properly center the electronic board in vertical direction. Now, the electronic board 7 is pushed downwards, i. e. towards the mounting frame 4, such that it slides along the third guiding elements 14 and second positioning pin 16 until the third snap connectors 11 engage the electronic board 7, in more detail respective edge sections thereof, and until the electronic board 7 abuts respective depth stops 19. As can be seen, a proper alignment of the electronic board 7 is automatically achieved upon snapping it into the mounting frame 4.

In the course of snapping the electronic board 7 into the mounting frame 4, the connector strip 21, i. e. respective contact elements, is/are automatically connected to a respective further connector strip 25, i. e. respective further contact elements of the electronic board 7. In this way, the touch-field unit 5 and the electronic board 7 are electrically connected in an automated manner, which simplifies and speeds up the mounting procedure. Establishing the electric contact between the touch-field unit 5 and the electronic board 7 is greatly facilitated by the fact that the touch-field unit 5 is properly aligned once mounted to the mounting frame 4, and that the electronic board 7 can be mounted to the mounting frame in proper alignment relative to the touch-field unit 5.

After mounting the touch-field unit 5 and electronic board 7, the actuator 8, or at least a circuit board 26 thereof, can be snap connected to the mounting frame 4. The actuator 8, in more detail the circuit board 26, can be put from the back side into the respective opening such that the second guiding elements 12 engage respective guiding notches. At this stage, the circuit board 26 can be pressed towards the mounting frame 4 such that the second snap connectors 10 engage the circuit board 26. In this way, the circuit board 26 is detachably mounted to the mounting frame 4 in proper alignment. After snap connecting the circuit board 26 to the mounting frame 4, further components of the actuator 8, such as a knob 27 and the like, can be connected to the circuit board 26 from the front or back side.

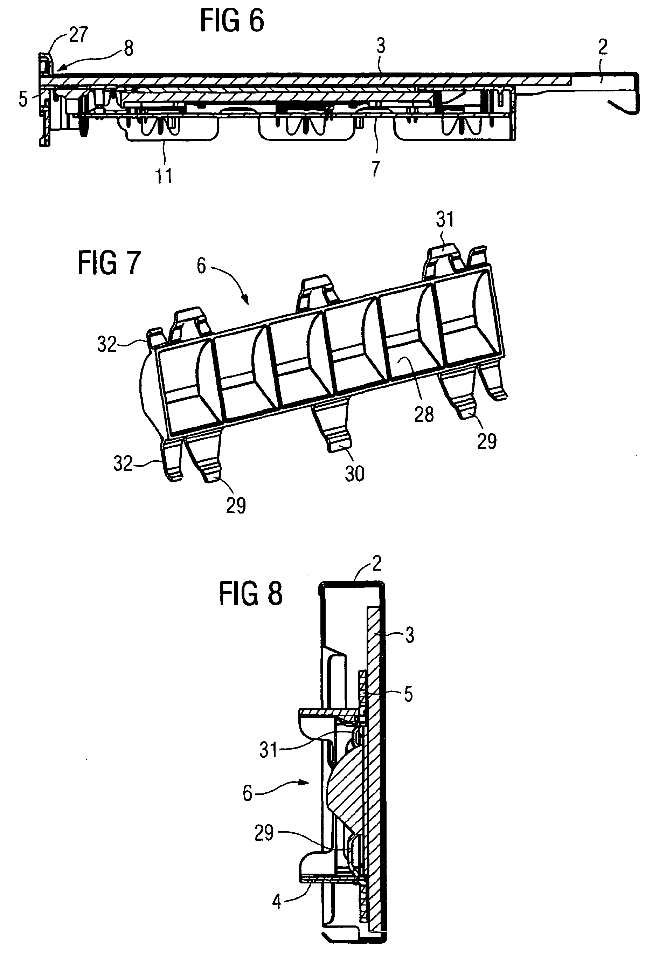

Fig. 6 shows a cross sectional partial view of the user interface 1. From Fig. 6 it becomes clear that the touch-field unit 5 is positioned immediately at the glass plate 3 and runs underneath the mounting section for the actuator 8 or circuit board 26. Further it can be seen, that the touch-field unit 5 and the electronic board 7 partially overlap in a region in which the connector strip 21 and further connector strip 25 are positioned. Such a partial overlap may be advantageous in view of mechanical stability, but is not mandatory. Such a configuration in particular allows to automatically establishing electronic contact between the touch-field unit 5 and electronic board 7.

Fig. 7 shows the reflector 6 in more detail. The reflector 6 comprises several reflector zones 28 corresponding to respective touch sensors 20. The reflector 6 further comprises outer spring hooks 29 and a central spring hook 30. In addition, the reflector 6 comprises reflector snap hooks 31 and optionally upper and lower reflector stops 32. The reflector 6 is mounted to the mounting frame 4 as follows, where further reference is made to Fig. 8 showing a cross sectional view of the user interface 1.

First, the outer spring hooks 29 and the central spring hook 30 are inserted into respective slots 33 (Fig. 2). Then, the reflector snap connectors 34 are engaged with the reflector snap hooks 31, in a pushing action for example. The reflector 6, in particular the outer spring hooks 29, the central spring hook 30 and the reflector snap hooks 31 are designed such that the reflector urges the touch-field unit 5 towards the glass plate 3. Thereby it can be assured that the touch-field unit 5 always is urged and butts against the glass plate 3, securing proper function of the touch sensors 20.

In general, the reflector 6 shall be properly aligned with respect to lateral, transversal and depth direction. If required, the upper and lower reflector stops 32 can be designed and adapted to fine tune depth alignment of the reflector 6. Further the central spring hook 30 and the respective slot 33 may be implemented with minimal play there between, thereby greatly restricting, or even preventing, lateral movability of the reflector 6.

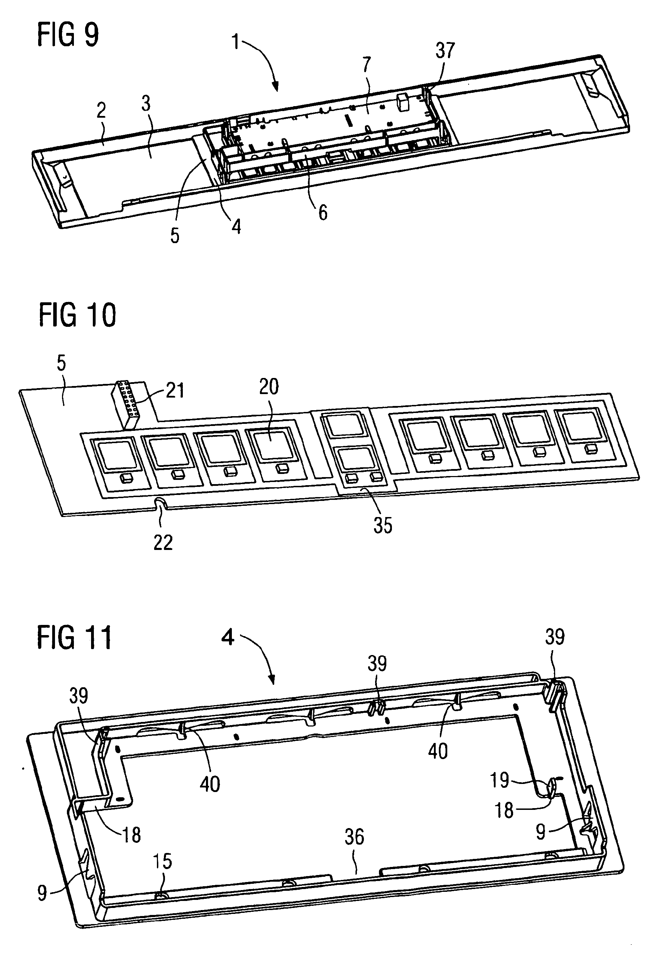

Fig. 9 shows a back view of a user interface 1 of a second embodiment. Note that the second embodiment is described only with respect to relevant constructional differences to the first embodiment. It shall be noted that all elements and components shown and described in connection with the first embodiment can be implemented with the second embodiment even if not expressly mentioned.

As becomes obvious from Fig. 9, the touch-field unit 5, the electronic board 7 and the reflector 6, which is only optional, are successively arranged one after the other with a maximum of overlap.

Fig. 10 shows a back view of the touch-field unit 5 of the user interface 1 of Fig. 9. The touch-field unit 5 comprises several touch sensors 20, a connector strip 21, a positioning notch 22 and a positioning edge 35.

Fig. 11 shows a back view of a respective mounting frame 4 to which the touch-field unit 5 is mounted to. The mounting frame 4 comprises a first positioning pin 15 and a positioning recess 36.

The touch-field unit 5 is mounted to the mounting frame 4 as follows: First, the positioning notch 22 is engaged with the first positioning pin 15. This secures the touch-field unit from lateral, i. e. horizontal, movement. In doing so, the lower edge of the touch-field unit 5 abuts a respective lower rim of the mounting frame 4 and the positioning edge 35 engages the positioning recess 36.

Then the touch-field unit 5 is pressed towards the mounting frame 5 such that the first snap connectors 9 engage respective sites of the touch-field unit 5. Once snapped in, upper left and right edges of the touch-field unit abut respective transversal stops, securing the touch-field unit 5 from transversal, i. e. vertical, movement. As can be seen, the touch-field unit 5 can easily be mounted in a detachable manner to the mounting frame 4, with the touch-field unit 5 being fixedly and properly aligned and secured.

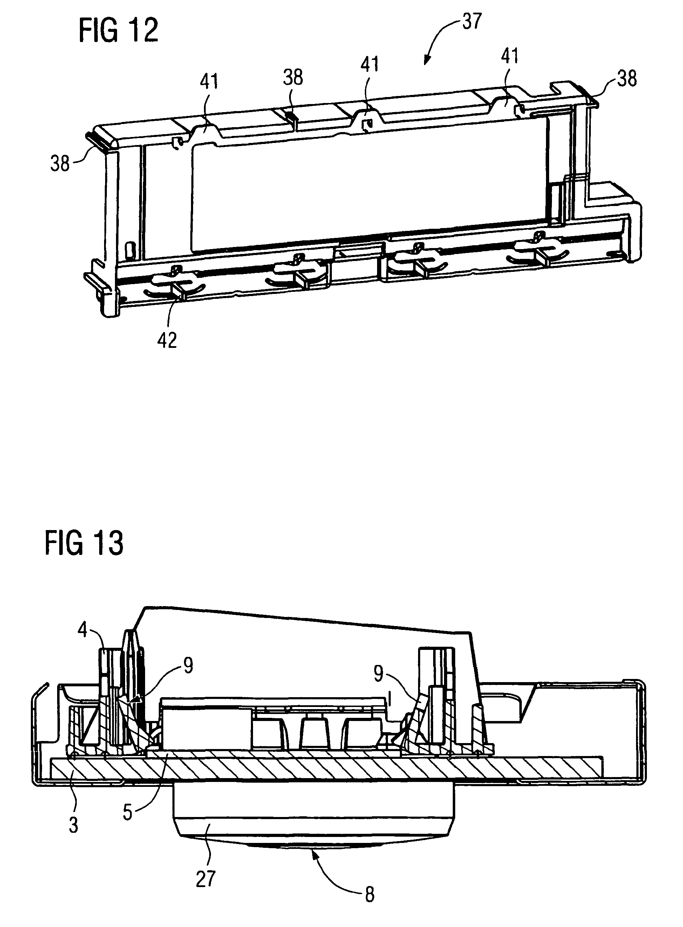

The electronic board 7 of the second embodiment is configured like the one of the first embodiment. In contrast to the first embodiment, the electronic board 7 in the present case is snap connected to a separate positioning frame 37 which is shown in more detail in Fig. 12. Snap connecting the electronic board 7 to the positioning frame 37 is conducted similarly to snap connecting the electronic board 7 of the first embodiment to the mounting frame 7. However, it is also or in addition possible that an upper or lower edge of the electronic board 7 first is inserted into retaining straps protruding from the positioning frame 37. Then the electronic board 7 can be pushed towards the positioning frame 37 thereby engaging respective snap connectors with respective snap sites of the electronic board 7. Further, any type of guides, lateral, transversal and depth stops can be provided in order to properly and fixedly align the electronic board 7 to the positioning frame 37.

Once the electronic board 7 is mounted to the positioning frame 37, the positioning frame 37 can be mounted to the mounting frame 4. This can be conducted as described below, where further reference is made to Fig. 12 showing a front view of the positioning frame 37, i. e. a side of the positioning frame 37 finally facing the touch-field unit 5.

First, the positioning frame 37 is placed on the mounting frame 4 such that third positioning pins 38 of the positioning frame 37 engage fourth guiding elements 39 of the mounting frame 4. Note that the positioning pins 38 and fourth guiding elements 39 can be interchanged.

Then the positioning frame is pushed towards the mounting frame 4, with the positioning pins 38 sliding along the fourth guiding elements 39, until fourth snap connectors 40 of the mounting frame 4 engage respective snap noses 41 of the positioning frame 37.

Via the positioning pins 38 and fourth guiding elements 39 the positioning frame 37 is properly and fixedly aligned relative to the mounting frame 4, and is also secured against lateral, i. e. horizontal, or transversal, i. e. vertical, movement. Depth stops 19 provided with the positioning frame 37 ensure that the positioning frame 37 is positioned at a proper mounting level.

Upon mounting the positioning frame 37 to the mounting frame 4, the connector strip 21 of touch-field unit 5 is automatically connected to a respective further connector strip provided on the electronic board. As the positioning pins 38 and guiding elements 39 prevent the positioning frame 37, and thereby the electronic board, from being tilted or moved in vertical or horizontal direction in the course of pushing them into the mounting frame 4, damages to the connector strip 21 and further connector strip or contact pins thereof can greatly be avoided.

Protrusions 42, in particular spring protrusions, protruding from a front side of the positioning frame, i. e. the side finally facing the touch-field unit 5, are designed and adapted to exert a pressing force upon the touch-field unit 5 in a direction towards the glass plate 3. The pressing force is such that the touch-field unit 5 is urged against the glass plate 3 in such a manner that optimal functionality and sensitivity of the touch sensors 20 can be achieved.

If a reflector 6 is to be mounted to the touch-field unit 5 of the second embodiment, the mounting frame 4 can comprise respective fastening elements, such as pin-hole-connector pairs, via which the reflector 6 can be attached to the mounting frame 4. In this case, the protrusions 42 mentioned beforehand, or additional protrusions, may be used to exert a pressing force upon the reflector 6 in turn urging the touch-field unit 5 towards the glass plate 3 such that the touch-field unit 5 properly abuts the glass plate 3. If the reflector 6 is situated between the protrusions 42 and the touch-field unit 5, the protrusions 42 can be shortened accordingly.

If desired, the user interface according to the second embodiment may further comprise an actuator 8 as already described in connection with the first embodiment.

Fig. 13 shows a cross sectional view a user interface in an actuator region. The actuator 8 comprises a circuit board 26 arranged at a back side, and a knob 27 arranged at a front side of the user interface 1. The circuit board 26 is snap connected to the mounting frame 4 as already described further above. The knob 27 can be inserted into a respective opening or hole of the glass panel 3 after the circuit board 26, and preferably the touch-field unit 5 and electronic board 7, is/are mounted to the mounting frame.

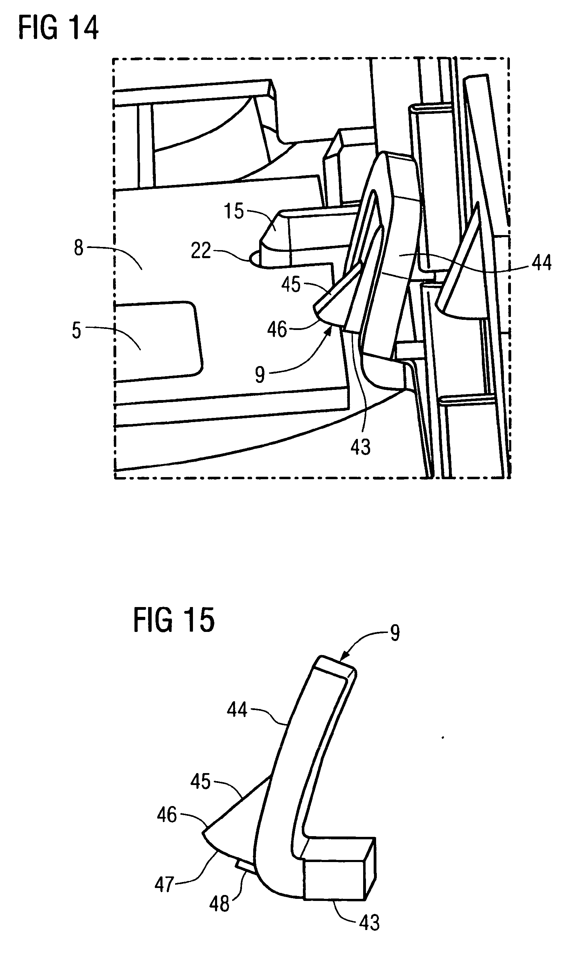

Fig. 14 shows a detail of a snap connection with respect to a snap connector 9 provided for snap connecting the touch-field unit 5. Fig. 15 shows an enlarged view of the snap connector 9. Albeit Fig. 14 shows a snap connection of the touch-field unit 5, the snap connection is not restricted to the touch-field-unit, but can be applied to all other snap connections mentioned so far, i. e. to first to fourth snap connectors 9 to 11 and 40. Therefore, the function of the snap connector 9 will be described in general terms using the term "element" instead of touch-field unit 5. However, for sake of simplicity, the reference sign 9 is representatively used for the snap connector.

The snap connector 9 comprises a base 43, from which a reversed U-shaped clip 44 extends upwardly. The clip 44 is resiliently connected or moulded to the base 43. Further, a detent element 45, in the present case comprising a detent hook 64 protruding in forward direction from the detent element 45, extends downwardly from an upper bar of the clip 44. The detent element 45 is resiliently connected or moulded to the upper bar, i. e. clip 44.

If an element, such as the touch-field unit 5, is snap connected, it is pushed downwards past the clip 44 and the detent element 45 is first moved backwards, away from the element. If the element has passed the detent element 45, the latter again moves in, i. e. forwards, thereby engaging the edge of the element. The detent element 45 prevents the element from moving up again. As a detent surface 47 is slanted and convex, the detent element 45 exerts to the element a pressing force acting obliquely downwards in forward direction.

The special configuration of the snap connector 9 allows to retrospectively increase the pressing force exerted on the element. As the clip 44 is resiliently connected to the base 43, the upper side of the clip 44, the upper bar for example, can be pushed backwards, i. e. in a direction opposite to the forward direction. In doing so, the detent surface 47 is elevated and the detent element 45 can move further in forward direction such that the overlap between the detent surface 47 and the element increases while the slanted detent surface 47 continuously abuts the element. By pushing the detent element outwards, the bias or spring force of the detent element 45 is increased and, as the detent surface 47 abuts the element, an increased pressing force is exerted on the element upon releasing the clip 44 again.

The detent element 45 can further comprise a step-like flap 48 protruding in downward direction of the detent element 45 and acting as lateral or transversal stop.

As can be seen, the retention force of the snap connector 9 can be increased retrospectively, leading to a safe and reliable snap connection. Further, the force needed to push the element past the snap connector 9 can first be kept at a comparatively low level, while in retrospect it is still possible to achieve comparatively high pressing forces.

It shall be noted, that edges of the element can be chamfered such that the force needed to push the element past the snap connectors can be kept at a low level as compared to sharp edges.

In all it becomes clear that the user interface as proposed herein can easily be assembled and disassembled again in a time saving manner but still allows to reliably and precisely position and fix respective elements.

### List of reference numerals

- 1: user interface
- 2: fixture
- 3: glass plate
- 4: mounting frame
- 5: touch-field unit
- 6: reflector
- 7: electronic board
- 8: actuator
- 9 - 11: first to third snap connectors
- 12 - 14: first to third guiding elements
- 15 - 16: first and second positioning pins
- 17: lateral stop
- 18: transversal stop
- 19: depth stop
- 20: touch sensor
- 21: connector strip
- 22: positioning notch
- 23: guiding notch
- 24: positioning hole
- 25: further connector strip
- 26: circuit board
- 27: knob
- 28: reflector zone
- 29: outer spring hook
- 30: central spring hook
- 31: reflector snap hook
- 32: upper and lower reflector stop
- 33: slot
- 34: reflector snap connector
- 35: positioning edge
- 36: positioning recess
- 37: positioning frame
- 38: third positioning pin
- 39: fourth guiding element
- 40: fourth snap connectors
- 41: snap nose
- 42: protrusion
- 43: base
- 44: clip
- 45: detent element
- 46: detent hook
- 47: detent surface
- 48: step-like flap

## Claims

1. Method of mounting a user interface for an appliance of household or industrial type, wherein a touch-field unit (5) is first pushed into the mounting frame (4) from a right hand side towards a left hand side in a slightly tilted manner, wherein the touch-field unit (5) is pushed into the mounting frame (4) underneath a section adapted to receive an actuator (8) whilst upper and lower edges of the touch-field unit (5) are guided by longitudinal guides respectively running from the right hand side to the left hand side, wherein the touch-field unit (5) is pushed towards the left hand side until its left face side abuts a lateral stop (17), and at this stage, the touch-field unit (5), in particular its right hand side, is pressed downwards such that snap connectors (9) positioned right-hand to the actuator mounting section engage the touch-field unit (5) in respective upper and lower edge sections, wherein subsequently, an electronic board (7) is put onto the right hand side of the mounting frame (4) onto second snap connectors (11), wherein the electronic board (7) is positioned in such a way that guiding elements (14) engage respective guiding notches (23) and a positioning pin (16) engages a positioning hole (24) of the electronic board (7), and wherein the electronic board (7) is pushed towards the mounting frame (4) such that it slides along the guiding elements (14) and positioning pin (16) until the second snap connectors (11) engage the electronic board (7) and until the electronic board (7) abuts respective depth stops (19), wherein in the course of snapping the electronic board (7) into the mounting frame (4), connector strips (21, 25) of the touch-field unit (5) and electronic board (7) are automatically connected.

2. Method according to claim 1, wherein guiding slots are used as the longitudinal guides, and wherein optionally snap connectors (9), guiding elements and depth stops (19) additionally are used as guiding elements.

## Patentansprüche

1. Verfahren zur Montage einer Benutzerschnittstelle für ein Haushalts- oder Industriegerät., wobei zuerst eine Berühxungsfeld-Einheit (5) von rechts nach links auf leicht geneigte Weise in den Montagerahmen (4) gedrückt wird, wobei die Berührungsfeld-Einheit (5) unterhalb eines Bereichs, der geeignet ist, einen Aktuator (8) aufzunehmen, in den Montagerahmen (4) gedrückt wird, während obere und untere Ränder der Berührungsfeld-Einheit (5) durch Längsführungen geführt werden, die jeweils von rechts nach links verlaufen, wobei die Berührungsfeld-Einheit (5) nach links gedrückt wird, bis ihre linke Seite an einen seitlichen Anschlag (17) anstößt, wobei in diesem Stadium die Berührungsfeld-Einheit (5), insbesondere ihre rechte Seite, nach unten gedrückt wird, so dass Schnappverbindungen (9), die rechts vom Aktuatormontagebereich angeordnet sind, in jeweiligen oberen und unteren Randbereichen in Eingriff mit der Berührungsfeld-Einheit (5) gelangen, wobei anschließend eine Elektronikplatine (7) an der rechten Seite des Montagerahmens (4) auf zweiten Schnappverbindungen (11) angeordnet wird, wobei die Elektronikplatine (7) derart angeordnet ist, dass Führungselemente (14) in Eingriff mit jeweiligen Führungsnuten (23) gelangen und ein Positionierungsstift (16) in ein Positionierungsloch (24) der Elektronikplatine (7) eingreift, und wobei die Elektronikplatine (7) zum Montagerahmen (4) hin gedrückt wird, so dass sie die Führungselemente (14) und den Positionierungsstift (16) entlang gleitet, bis die zweiten Schnappverbindungen (11) in Eingriff mit der Elektronikplatine (7) gelangen und bis die Elektronikplatine (7) an jeweilige Tiefenanschläge (19) anstößt, wobei im Verlauf des Einschnappens der Elektronikplatine (7) in den Montagerahmen (4) Anschlussstreifen (21, 25) der Berührungsfeld-Einheit (5) und der Elektronikplatine (7) automatisch miteinander verbunden werden.

2. Verfahren nach Anspruch 1, wobei Führungsschlitze als Längsführungen verwendet werden und wobei wahlweise zusätzlich Schnappverbindungen (9), Führungselemente und Tiefenanschläge (19) als Führungselemente verwendet werden.

## Revendications

1. Procédé pour monter une interface utilisateur pour un appareil de type domestique ou industriel, dans lequel une unité de panneau tactile (5) est tout d'abord poussée dans le bâti de montage (4) d'un côté droit vers un côté gauche d'une manière légèrement inclinée, dans lequel l'unité de panneau tactile (5) est poussée dans le bâti de montage (4) sous une section adaptée pour recevoir un actionneur (8) alors que les bords supérieur et inférieur de l'unité de panneau tactile (5) sont guidés par des guides longitudinaux s'étendant respectivement du côté droit vers le côté gauche, dans lequel l'unité de panneau tactile (5) est poussée vers le côté gauche jusqu'à ce que son côté de face gauche vienne en butée contre une butée latérale (17), et à ce stade, l'unité de panneau tactile (5), en particulier son côté droit, est pressée vers le bas de sorte que des ressorts à ergot (9) positionnés à droite de la section de montage d'actionneur mettent en prise l'unité de panneau tactile (5) dans les sections de bords supérieur et inférieur respectives, dans lequel ensuite, une carte électronique (7) est placée sur la côté droit du bâti de montage (4) sur des seconds ressorts à ergot (11), dans lequel la carte électronique (7) est positionnée de sorte que des éléments de guidage (14) mettent en prise des encoches de guidage (23) respectives et une broche de positionnement (16) met en prise un trou de positionnement (24) de la carte électronique (7), et dans lequel la carte électronique (7) est poussée vers le bâti de montage (4) de sorte qu'elle coulisse le long des éléments de guidage (14) et de la broche de positionnement (16) jusqu'à ce que les seconds ressorts à ergot (11) mettent en prise la carte électronique (7) et jusqu'à ce que la carte électronique (7) vienne en butée contre des butées de profondeur (19) respectives, dans lequel au cours de l'encliquetage de la carte électronique (7) sur le bâti de montage (4), des bandes de connecteur (21, 25) de l'unité de panneau tactile (5) et de la carte électronique (7) sont automatiquement raccordées.

2. Procédé selon la revendication 1, dans lequel des fentes de guidage sont utilisées en tant que guides longitudinaux, et dans lequel facultativement des ressorts à ergot (9), des éléments de guidage et des butées de profondeur (19) sont utilisés en plus en tant qu'éléments de guidage.
